# EUROPÄISCHE PATENTANMELDUNG

(11) **EP 0 569 660 A1**
(43) Veröffentlichungstag der Anmeldung: **18.11.1993**
(21) Anmeldenummer: 93100527.6
(22) Anmeldetag: 15.01.1993
(51) Int. Cl.: C23C 14/04, C23C 16/04, C23C 16/44, C23C 14/50

(54) **Vorrichtung zum Halten von Substraten**

(30) Priorität: 15.05.1992 DE 9206635 U
(71) Anmelder: LEYBOLD AKTIENGESELLSCHAFT, D-63450 Hanau (DE)
(72) Erfinder: Latz, Rudolf, Dr., W-6054 Rodgau (DE); Ritter, Jochen, W-6312 Laubach 1 (DE)

(57) **Zusammenfassung**

Vorrichtung zum Halten von im wesentlichen ebenen Substraten (1) während eines Beschichtungsverfahrens, wie beispielsweise einem Sputter-, Aufdampf- oder CVD-Verfahren, bestehend aus einem mindestens zweiteiligen Substrathalter, wobei ein vorderer Teil (4) des Substrathalters die zur Beschichtungsquelle hingerichtete Substratoberfläche maskenartig abdeckt und ein zweiter rückseitiger Teil des Substrathalters (8) auf der der Beschichtungsquelle abgewandten Rückseite des Substrats vorgesehen ist und eine folienartige, elastische Maske (6) mit dem vorderen Substrathalter verbunden ist und die Kontur der Maske so ausgeformt ist, daß der Maskenrand den Substrathalter in einem vorzugsweise parallelen Abstand überragt, die Maske durch den Substrathalter in einem Winkel (δ) auf die zu beschichtenden Oberfläche (10) des Substrats geführt ist und der über den Substrathalter hinausragende Maskenrand auf die Oberseite des Substrats andrückbar ist.

## Beschreibung

Die Erfindung betrifft eine Vorrichtung zum Halten von im wesentlichen ebenen Substraten während eines Beschichtungsverfahrens, wie beispielsweise einem Sputter-, Aufdampf- oder CVD-Verfahren, bestehend aus einem mindestens zweiteiligen Substrathalter, wobei ein vorderer Teil des Substrathalters die zur Beschichtungsquelle hingerichtete Substratoberfläche maskenartig abdeckt und ein zweiter rückseitiger Teil des Substrathalters auf der der Beschichtungsquelle abgewandten Rückseite des Substrats vorgesehen ist.

Beim Beschichten von Substraten besteht häufig die Forderung nur einen Teil der Substratoberfläche zu beschichten. Dies ist beispielsweise bei Bildschirmen der Fall, wo der äußere Rand der Substratvorderseite nicht beschichtet werden soll.

Hierfür wurden bislang überwiegend ebene Maskenbleche verwendet, die auf die zu beschichtende Substratvorderseite aufgelegt oder gegebenenfalls aufgedrückt wurden. Dabei ist jedoch besonders darauf zu achten, daß die durch die Maske strukturierte Schicht einen sehr schmalen Übergangsbereich aufweist, d.h. daß die Schichtstufe vom beschichteten zum unbeschichteten Bereich scharf abgegrenzt ist. Die Breite dieses Übergangsbereichs hängt im wesentlichen von drei Faktoren ab:
1. dem Auftreffwinkel, unter dem die Beschichtungsteilchen auf dem Substrat-Maskenbereich auftreffen,
2. der Dicke des Maskeumaterials an der begrenzenden Kante und
3. dem Abstand der Maske vom Substrat.

Diese bislang verwendete Lösung hat jedoch den Nachteil, daß sowohl die Maske als auch das Substrat sehr eben sein müssen und nicht gewölbt sein dürfen, damit ein dichter Masken-Substrat-Abschluß herstellbar ist. Dies ist insbesondere bei großen Masken und Substraten problematisch.

Aufgabe ist es nun, eine Möglichkeit zu finden, so daß bei der Herstellung strukturierter Schichten auf Substraten stets eine scharfe Schichtstufe im Übergangsbereich von der beschichteten zur unbeschichteten Substratoberfläche erreichbar ist.

Diese Aufgabe wird durch die vorliegenden Erfindung dadurch gelöst, daß eine folienartige, elastische Maske mit dem vorderen Substrathalter verbunden ist und die Kontur der Maske so ausgeformt ist, daß der Maskenrand den Substrathalter in einem vorzugsweise parallelen Abstand überragt, die Maske durch den Substrathalter in einem Winkel auf die zu beschichtenden Oberfläche des Substrats geführt ist und der über den Substrathalter hinausragende Maskenrand auf die Oberseite des Substrats andrückbar ist.

Dadurch wird mit Vorteil ermöglicht, daß selbst wenn Unebenheiten auf der Substratoberfläche oder in der Maske vorliegen, die Maske immer dicht auf dem Substrat aufliegt.
Weitere Ausführungsmöglichkeiten und Merkmale sind in den Unteransprüchen näher beschrieben und gekennzeichnet.

In einem Ausführungsbeispiel wurden für die Beschichtung von Bildschirmen eine Schichtdicke von ca. 150 nm auf die Substrate aufgebracht. Die Dicke der verwendeten Maske aus Kupfer-Berylliumfolie betrug 0,1 mm. Der Maskenwinkel δ, d.h. der Auftreffwinkel der Maskenfolie auf die Substratoberfläche lag zwischen ca. 20 und 30° .
Die durch den Beschichtungsvorgang bedingten Temperaturen, denen die Maske ausgesetzt ist, lagen im Bereich von 200° C.

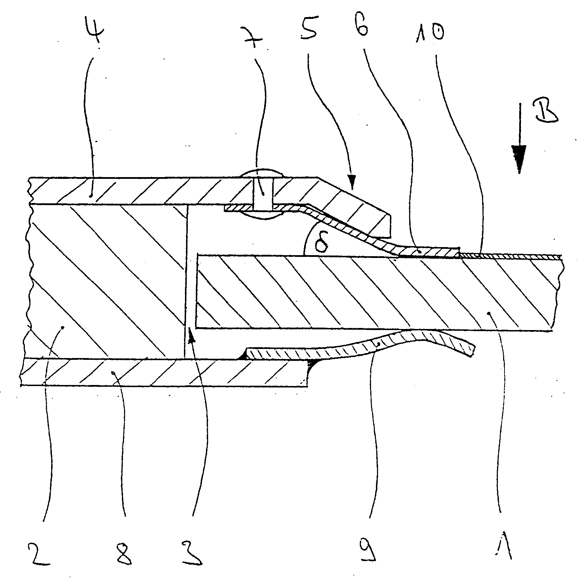

Die Erfindung läßt die verschiedenartigsten Ausführungsmöglichkeiten zu; eine davon ist in der anhängenden einzigen Figur näher dargestellt, und zwar zeigt diese den Randbereich eines zu beschichtenden Substrats mit einer erfindungsgemäßen Maske in Schnittdarstellung.

Ein zu beschichtendes ebenes Substrat 1 ist in Umfangsrichtung von einem Grundkörper 2, der in einer nicht gezeigten Vakuumkammer vorgesehen ist so umgeben, daß zwischen den beiden gegenüber angeordneten Stirnseiten des Substrats 1 und des Grundkörpers 2 ein schmaler Spalt 3 verbleibt. Auf der ebenen Vorderseite des Grundkörpers 2 ist ein vorderer Substrathalter 4 befestigt, welcher zur Beschichtungsquelle hin zeigt. Die Beschichtungsquelle selbst ist der Einfachheit halber nicht gezeigt; jedoch ist ihre Lage durch die Beschichtungsrichtung B eindeutig bestimmbar. Der im wesentlichen ebene Substrathalter 4 ist an seinem freien Ende, welches zur Substratmitte hin zeigt, mit einem nasenförmigen Knick 5 versehen, wobei der Knick 5 in Beschichtungsrichtung B auf das Substrat 1 hin ausgerichtet ist.

Auf der Rückseite des Substrathalters 4 ist eine flexible Maske 6 befestigt, wobei die Befestigung beispielsweise mittels Niet 7 erfolgen kann. Die Maske 6 besteht aus einem Werkstoff mit einer definierten Eigensteifigkeit, ist folienartig und in Ihrer ursprünglichen Form eben. Durch den Knick 5 wird die Maske 6 um den Winkel δ in Richtung auf das Substrat 1 hin gebogen. Das Substrat 1 wird durch eine, mit dem rückseitigen Substrathalter 8 fest verbundene Haltefeder 9 gegen die Maske 6 gedrückt. Dabei gleitet die um den Winkel δ vorgebogene Maske 6 auf der zu beschichtenden Vorderseite des Substrats 1 zur Substratmitte hin, bis das elastische Ende der Maske 6 parallel zur Vorderseite des Substrats 1 verläuft und dicht auf diesem aufliegt.

Aus der Beschichtungsrichtung B wird nun eine Schicht 10 auf das Substrat 1 aufgebracht, welche an ihrem in Umfangrichtung äußeren Rand durch die Maske 6 scharfkantig begrenzt wird.

### Bezugszeichenliste

- 1: Substrat
- 2: Grundkörper
- 3: Spalt
- 4: vorderer Substrathalter
- 5: Knick, Schräge
- 6: Maske
- 7: Niet, Bolzen
- 8: rückseitiger Substrathalter
- 9: Haltefeder
- 10: Schicht
- B: Beschichtungsrichtung
- δ: Winkel, Maskenwinkel

## Patentansprüche

1. Vorrichtung zum Halten von im wesentlichen ebenen Substraten (1) während eines Beschichtungsverfahrens, wie beispielsweise einem Sputter-, Aufdampf- oder CVD-Verfahren, bestehend aus einem mindestens zweiteiligen Substrathalter, wobei ein vorderer Teil des Substrathalters die zur Beschichtungsquelle hingerichtete Substratoberfläche maskenartig abdeckt und ein zweiter rückseitiger Teil des Substrathalters (8) auf der der Beschichtungsquelle abgewandten Rückseite des Substrats (1) vorgesehen ist, **dadurch gekennzeichnet,** daß eine folienartige, elastische Maske (6) mit dem vorderen Substrathalter (4) verbunden ist und die Kontur der Maske (6) so ausgeformt ist, daß der Maskenrand den Substrathalter (4) in einem vorzugsweise parallelen Abstand überragt, die Maske (6) durch den Substrathalter (4) in einem Winkel (δ) auf die zu beschichtenden Oberfläche des Substrats (1) geführt ist und der über den Substrathalter (4) hinausragende Maskenrand auf die Oberseite des Substrats (1) andrückbar ist.

2. Vorrichtung nach Anspruch 1, **dadurch gekennzeichnet,** daß an dem rückseitigen Substrathalter (8) Haltefedern (9) vorgesehen sind.

3. Vorrichtung nach Anspruch 2, **dadurch gekennzeichnet,** daß das Substrat (1) mittels der Haltefedern (9) gegen die Maske (6) andrückbar ist.

4. Vorrichtung nach Anspruch 1, **dadurch gekennzeichnet,** daß die Maske (6) aus einem Werkstoff mit einer definierten Eigensteifigkeit besteht.

5. Vorrichtung nach Anspruch 4, **dadurch gekennzeichnet,** daß die Maske (6) aus einem Cr-Ni-Stahl oder einer Cu-Be-Legierung hergestellt ist.

6. Vorrichtung nach Anspruch 1, **dadurch gekennzeich net,** daß der vordere Substrathalter (4) einen nasenförmigen Knick (5) aufweist.

7. Vorrichtung nach Anspruch 6, **dadurch gekennzeichnet**, daß der Knick (5) einen Winkel (6) zur Substratoberfläche aufweist.

8. Vorrichtung nach Anspruch 1. **dadurch gekennzeichnet,** daß die Maske (6) auf der der Beschichtungsquelle abgewandten Rückseite des Substrathalters (4) befestigt ist.

9. Vorrichtung nach Anspruch 1, **dadurch gekennzeichnet,** daß die Dicke der Maske (6) um ein Vielfaches größer gewählt ist, als die Dicke der auf das Sustrat (1) aufzubringenden Schicht (10).

10. Vorrichtung nach Anspruch 1 oder 4, **dadurch gekennzeichnet,** daß die Eigensteifigkeit der Maske (6) so gewählt ist, daß die Maske (6) jeder Unebenheit der Substratoberfläche folgt und dicht auf der Substratoberfläche aufliegt.

11. Vorrichtung nach Anspruch 1, **dadurch gekennzeichnet,** daß die Maske (6) rahmenförmig ausgebildet ist.

12. Vorrichtung nach Anspruch 11, **dadurch gekennzeichnet,** daß die Maske (6) einen in Umfangsrichtung außen liegenden Rand der Substratoberfläche abdeckt.

13. Vorrichtung nach Anspruch 1, **dadurch gekennzeichnet,** daß die Maske (6) in jeder beliebigen Form ausbildbar ist.
